# EUROPEAN PATENT APPLICATION

(11) **EP 1 113 484 A2**
(43) Date of publication of application: **04.07.2001**
(21) Application number: 00311770.2
(22) Date of filing: 29.12.2000
(51) Int. Cl.: H01L 21/02

(54) **Iridium and iridium oxide electrodes used in ferroelectric capacitors**

(30) Priority: 30.12.1999 US 173868 P
(71) Applicant: Applied Materials, Inc., Santa Clara, California 95054 (US)
(72) Inventor: Abooameri, Farid, Santa Clara CA 95051 (US); Sivaramakrishnan, Visweswaren, Santa Clara CA 95051 (US); Singh, Kausal K., Santa Clara CA 95051 (US); Sajoto, Talex, Campbell CA 95011 (US); Zhao, Jun, Cupertino CA 95014 (US); Lim, Vicente, Newark CA 94560 (US)
(74) Representative: Bayliss, Geoffrey Cyril

(57) **Abstract**

The present invention provides a capicitor having upper and lower electrodes formed of iridium or iridium oxide or combinations thereof. The electrodes are preferably formed using physical vapor deposition. An insulating layer disposed between the electrodes can be a ferroelectric ceramic such as PZT or PLZT.

## Description

The present invention relates to semiconductor devices such as DRAMs and nonvolatile RAMs, and piezoelectric, pyroelectric and optoelectric devices using ferroelectric ceramics such as lead zirconate titanate (PZT) and lead lanthanum zirconate titanate (PLZT) in an insulating layer, and a method of manufacturing the same.

Ferroelectric ceramics such as PbTiO₃, PZT and PLZT are utilized in piezoelectric, pyroelectric and optoelectric devices and the like. The application thereof ranges widely over the fields of oscillators, filters, infrared sensors and the like.

In recent years, attention has been directed to ferromagnetic ceramics as a dielectric material for forming the capacitance of DRAMs and nonvolatile RAMs. These ceramics have applicability to nonvolatile semiconductor memories due to the fact that once voltage is applied utilizing ferroelectricity, the data can be maintained even if the voltage is removed. The potential of these materials for application to memory cells in high density semiconductor memory devices is great since ferroelectric ceramics with high dielectric constants can store a large amount of charge even in capacitors having high integration density in a small electrode area.

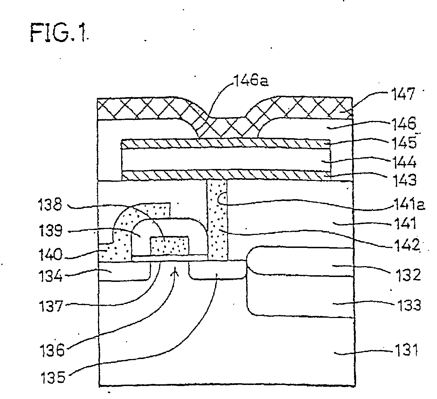

Figure 1 shows a conventional DRAM using ferroelectric ceramics as a dielectric of a stack-typed capacitor. Referring to Figure 1, the conventional DRAM has an isolation oxide film 132 for element isolation formed at a predetermined region on the main surface of a silicon semiconductor substrate 131. A channel stop layer 133 is formed beneath the isolation oxide film 132. In the region surrounded by isolation oxide film 132, source/drain regions 134 and 135 with a predetermined distance therebetween are formed and define a channel region 136 therebetween. A gate electrode 138 is formed on channel region 136 with a gate insulating film 137 formed therebetween. An insulating film 139 is formed over gate electrode 138. A buried bit line 140 electrically connected to source/drain region 134 is formed so as to extend along the surface of insulating film 139. An interlayer insulating film 141 having a contact hole 141a is formed on source/drain region 135. An interconnection layer 142 of polysilicon is formed in contact hole 141a to electrically contact the source/drain region 135. A platinum layer 143 is formed on interconnection 142 and extends above interlayer insulating film 141. A ferroelectric film 144, such as PZT, is formed on platinum layer 143. An upper electrode 145 made of platinum is formed on ferroelectric film 144. An interlayer insulating film 146 having a contact hole 146a is formed on capacitor upper electrode 145. An inner connection layer 147 is formed on inner layer insulating film 146 and is electrically connected to capacitor upper electrode 145. In such a structure, a capacitor lower electrode is formed of interconnection layer 142 and platinum layer 143.

Issues with using platinum as the electrode material in capacitor devices are non-homogeneous growth of PZT on platinum films and segregated lead rich and lead deficient areas. These problems have been seen in SEM and optical micrograph studies. Non-homogeneous growth of PZT films result in a film having a dielectric constant less than desirable. In addition, lead rich and lead deficient areas also result in lower dielectric constant of the PZT film.

Therefore there is a need for a method of forming a capacitor using PZT which utilizes an electrode material which promotes deposition of homogeneous perovskite PZT and grain sizes of approximately 1000 angstroms.

The present invention is directed generally to the deposition of iridium and iridium oxide electrodes using physical vapor deposition. In one aspect, iridium or iridium oxide is deposited using a physical vapor deposition chamber which includes a pulsed dc power supply. A ferroelectric ceramic layer, such as PZT or PLZT is deposited over a lower electrode made of iridium or iridium oxide. An upper electrode of iridium or iridium oxide is then deposited on the ferroelectric ceramic.

So that the manner in which the above recited features, advantages and objects of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.

Figure 1 is a cross-sectional view of a substrate having a capacitor formed thereon.

Figure 2 is a cross-sectional schematic view of a physical vapor deposition chamber for depositing iridium and iridium oxide.

Figures 3 and 4 are SIMS results showing lead diffusion in platinum and iridium electrodes.

Figures 5 and 6 are SEM results showing phase segregation of PZT on a platinum substrate and homogeneous perovskite deposition on an iridium substrate.

Figures 7 and 8 are optical micrographs of a PZT surface and bottom showing the difference in surface methodology.

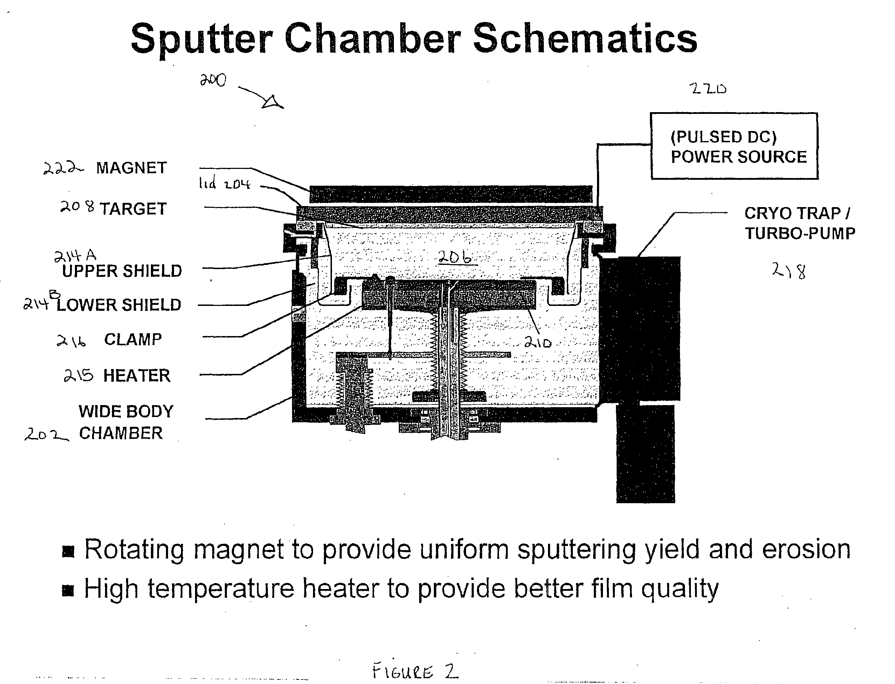

Figure 2 is a cross-sectional view of an exemplary chamber 200 used to deposit iridium or iridium oxide on a substrate to form the electrodes of a capacitor. The chamber generally includes a chamber body 202 and a lid 204 defining an enclosure 206. A target 208 of the material to be sputtered, for example iridium, is disposed on the lower surface of the lid 204. A substrate support member 210 is disposed within the chamber and extends partially therethrough. The substrate support member is connected to an actuator (not shown) to move the substrate support member vertically within the chamber to position a substrate for processing. Upper and lower shields 214A-B are disposed in the chamber to protect the lower portion of the chamber from deposition material. In addition, the upper and lower shields provide surfaces for easy removal during cleaning or other maintenance procedures. An annular clamp ring 216 is supported in the chamber on the lower shield when the substrate support member is in the lowered position. Upon elevation of the substrate support member into a processing position, the clamp ring rests on the upper surface of the substrate to hold the substrate on the substrate support member. The support member preferably includes a resistive heating element 215 disposed therein to heat the substrate to high temperature (e.g., up to 600°C). A cryopump and turbo pump 218 are connected to the chamber to enable ultra high vacuum to be achieved therein. A pulse DC power source 220 is connected to the target to facilitate the generation of a plasma between the upper surface of the support member and the lower surface of the target. Typically, the chamber body and the support member are maintained at a ground potential in order to enable a plasma to be generated via capacitive coupling. A rotating magnet 222 can be provided on the backside of the target to provide uniform sputtering yield and erosion patterns on the surface of the target.

An exemplary deposition procedure used within the chamber to deposit an iridium electrode on a 200mm substrate is shown in Table I. Generally, the pressure in the chamber is maintained at about 3-5 millitorr with an argon flow rate of 40-61 sccm. Argon flow to the heater is provided at about 15 sccm. The heater temperature is maintained at about 400-550°C during deposition. The heater is spaced about 56-72 millimeters from the lower surface of the target. A DC power of about 500-2000 watts is applied to the target and deposition occurs for about 49 seconds to deposit 1000 angstroms. In some embodiments, the power selected to match the film stress of the material below the electrode.

**Table 1**

| | |
|---|---|
| Pressure/Ar Flow | 4 [mT] / 61 [sccm] |
| Ar Heater Flow | 15 [sccm] |
| Heater Temperature | 475 [°C] |
| Spacing | 56 [mm] |
| DC Power | 2000 [W] |
| Time to Deposit 1000Å | 49 [sec] |

A film deposited using the process parameters shown in Table 1 has the characteristics shown in Table 2. Generally, the sheet resistance for the iridium film is 1.44 Ω/ . The sheet resistance non-uniformity (NU) (6mm edge exclusion) is 6.8% 1σ. The resistivity is 15 µΩcm. The deposition rate was 1250 angstroms/minute. The film stress is -148 MPa. The Rms is 5.7Å, Ra is 4.5 Å and Rmax is 59.8 Å.

**Table 2**

| Film Properties for 1000Å Ir Film: | |
|---|---|
| Sheet Resistance | 1.44 [Ω/ ] |
| Sheet Resistance NU (6 mm ee) | 6.8% (1σ) |
| Resistivity | 15 [µΩ.cm] |
| Deposition Rate | 1250 [Å/min] |
| Stress | -148 [Mpa] |
| Roughness (Rms) | 5.7 [Å] |
| Roughness (Ra) | 4.5 [Å] |
| Roughness (Rmax) | 59.8 [Å] |

An exemplary process to deposit iridium oxide on a 200mm substrate is set forth in Table 3. Generally, the pressure in the chamber is maintained at about 5-10 millitorr and argon is flowed into the chamber at a rate of about 65-130 sccm. Argon flow to the support member (heater) is about 15 sccm. Oxygen is flowed into the chamber at rate sufficient to maintain a concentration of between about 30% and 50% of the total gas flow into the chamber. In the particular embodiment shown in Table 3, the gas flow is about 87 sccm. The support member temperature is about 530-550°C. The substrate support member is spaced about 56-72 millimeters from the target. A DC power of about 500-3000 watts is applied to the target and the deposition time is about 13 seconds for 1000 angstroms.

**Table 3**

| | |
|---|---|
| Pressure/Ar Flow | 10 [mT] / 130 [sccm] |
| Oxygen Flow | 87 [sccm] |
| Ar Heater Flow | 15 [sccm] |
| Heater Temperature | 530 [°C] |
| Spacing | 70 [mm] |
| DC Power | 3000 [W] |
| Time to Deposit 1000Å | 13 [sec] |

The film properties for 2300 angstroms of iridium oxide film are set forth in Table 4. The sheet resistance is 6.30 Ω/ . The sheet resistance is 10.77 1σ. The resistivity is 145 µΩcm. The deposition rate is 4600 angstroms/minute. The stress is -2277 MPa. The Rms is 34.6 Å, the Ra 27.1 Å, and Rmax is 356.0 Å.

**Table 4**

| Film Properties for 2300 Å IrO₂ Film: | |
|---|---|
| Sheet Resistance | 6.30 [Ω/ ] |
| Sheet Resistance NU(5 mm ee) | 10.77 (1σ) |
| Resistivity | 145 [µΩ.cm] |
| Deposition Rate | 4600 [Å/min] |
| Stress | -2277 [Mpa] |
| Rms | 34.6 [Å] |
| Ra | 27.1 [Å] |
| Rmax | 356.0 [Å] |

In a capacitor structure of the invention, the pair of electrodes are preferably made of iridium or iridium oxide. The main insulating layer of the capacitor is comprised of PZT which has a perovskite type crystal structure.

In forming the above described capacitor structure, an electrode such as of iridium or iridium oxide, a main insulating layer, and the other electrode are deposited in order. The electrodes are preferably deposited by physical vapor deposition such as sputtering. The main insulating layer of PZT can be formed for example by a liquid phase method such as sol gel deposition, PVD, or CVD e.g., MOCVD. The main insulating layer can be formed to a thickness of about 1000 or 2000 angstroms, for example, preferably or possibly 1500 angstroms.

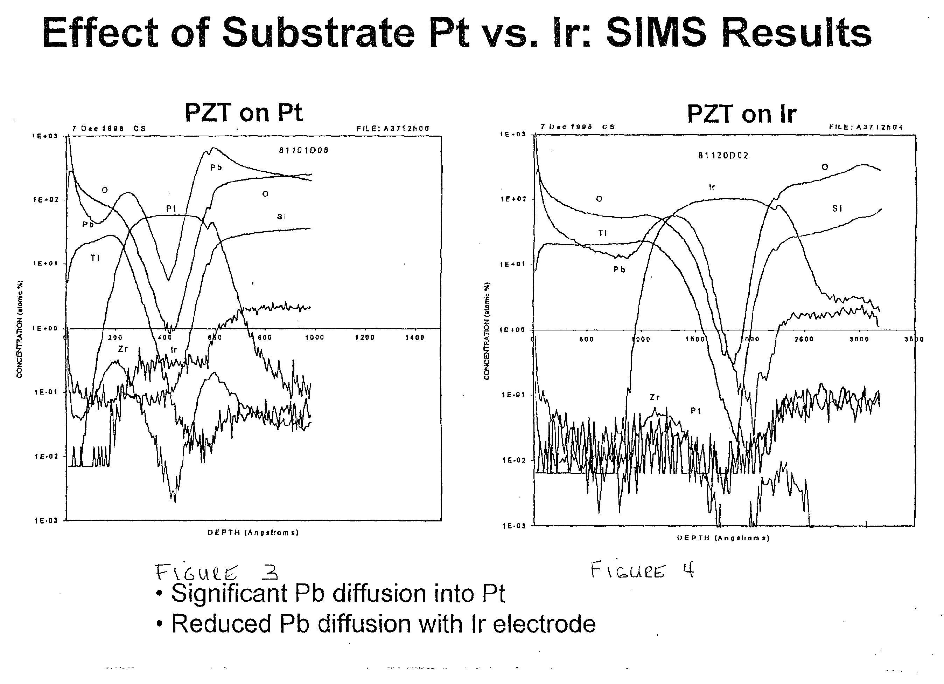

It is believed that the use of iridium or iridium oxide as an electrode in a capacitor device significantly reduces the diffusion of lead from the PZT insulating layer into the electrode. In conventional devices using platinum, a significant amount of lead diffuses into the platinum electrode. It is believed that diffusion of lead into an iridium electrode is minimal. SIMS results shown in Figures 3 and 4 confirm the reduction of lead diffusion with an iridium electrode.

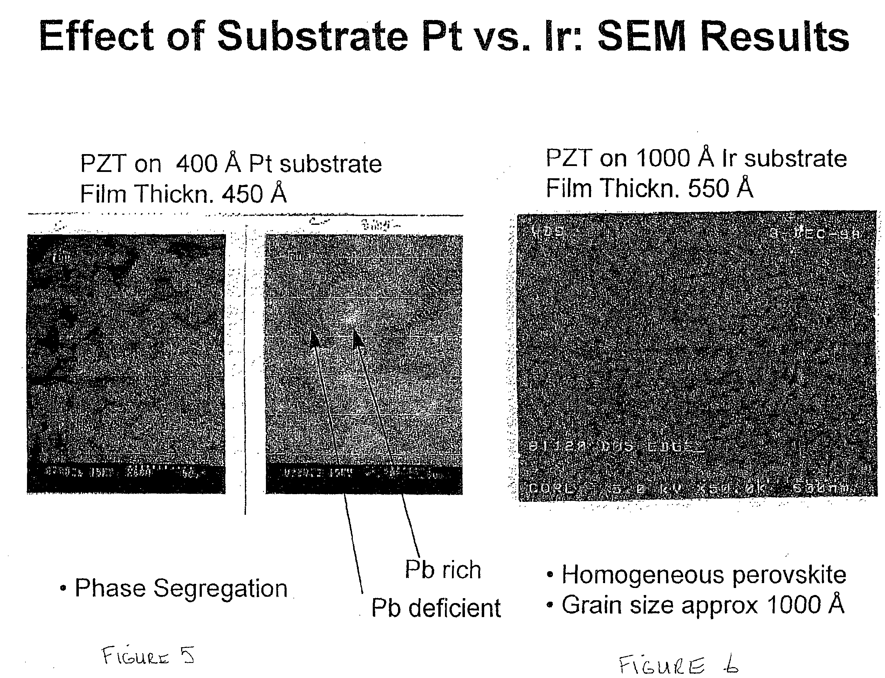

In addition, PZT deposited on 400 angstroms of platinum shows phase segregation between the components of the PZT film as shown, for example, in Figure 5. Lead rich and lead deficient areas can be seen on the SEM photograph. In contrast, as shown in Figure 6, PZT deposited on 1000 angstroms of iridium at a film thickness of about 550 angstroms shows a homogeneous perovskite film having a grain size of approximately 1000 angstroms.

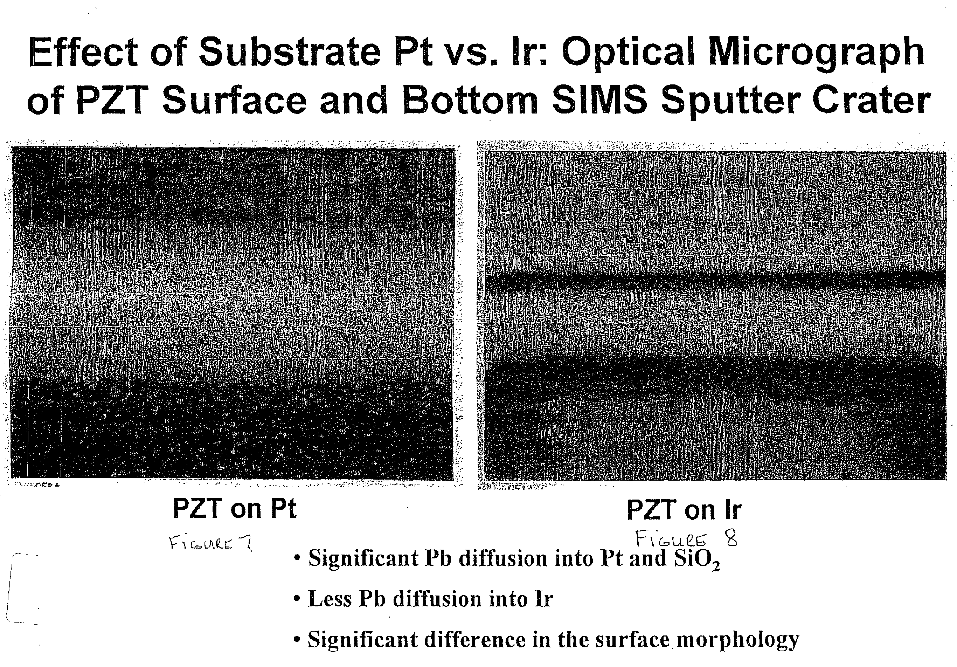

It is also believed that iridium and iridium oxide are stable conductors with more resistance to lead diffusion compared to platinum. PZT deposited or an iridium or iridium oxide film results in homogeneous perovskite. Surface morphology of PZT on iridium is smooth as opposed to rough and hazy on platinum as shown in Figures 7 and 8.

While the foregoing is directed to the preferred embodiment of the present invention, other and further embodiments of the invention may be devised without departing from the basic scope thereof, and the scope thereof is determined by the claims that follow.

## Claims

1. A capacitor structure comprising:
a lower electrode formed of a material selected from iridium, iridium oxide and combinations thereof;
an insulating layer made of a ferroelectric ceramic formed over the lower electrode; and
an upper electrode formed of a material selected from iridium, iridium oxide and combinations thereof formed over the insulating layer.

2. The capacitor structure of claim 1, wherein the material of the lower electrode and upper electrode are iridium and have a sheet resistance of no more than 1.44 Ω.

3. The capacitor structure of claim 1, wherein the material of the lower electrode and upper electrode are iridium oxide and have a sheet resistance of no more than 6.30 Ω.

4. A method of forming a capacitor, the method comprising:
depositing a lower electrode made of a material selected from iridium, iridium oxide and combinations thereof;
depositing a ferroelectric ceramic selected from lead zirconate titanate (PZT) and lead lanthanum zirconate titanate (PLZT); and
depositing an upper electrode over the ferroelectric ceramic, the upper electrode being made of a material selected from iridium, iridium oxide and combinations thereof.

5. The method of claim 4, wherein at least one of the electrodes is deposited using physical vapor deposition.

6. The method of claim 4 or claim 5, wherein the ferroelectric ceramic is deposited by sol gel deposition, physical vapor deposition, or chemical vapor deposition.

7. A capacitor structure comprising:
a first electrode formed of a material selected from an iridium containing material; and
an insulating layer in contact with the first electrode and made of a ferroelectric ceramic.

8. The capacitor structure of claim 7, wherein the material is one of iridium, iridium oxide and combinations thereof.

9. The capacitor structure of any one of claims 1 to 8, wherein the insulating layer is selected from one of PZT and PLZT.

10. The capacitor structure of any one of claims 7 to 9, wherein the first electrode is one of a top electrode and a bottom electrode.

11. The capacitor structure of any one of claims to 10, wherein at least one of the electrodes is deposited using physical vapor deposition.

12. The capacitor structure of any one of claims 1 to 11, wherein the ferroelectric ceramic is deposited by sol gel deposition, physical vapor deposition, or chemical vapor deposition.

13. The capacitor structure of claim 7, wherein the ferroelectric ceramic is selected from one of PZT and PLZT and the material is one of iridium, iridium oxide and combinations thereof.

14. The capacitor structure of claim 7, wherein the ferroelectric ceramic is selected from one of PZT and PLZT and the material is iridium having a sheet resistance of no more than 1.44 Ω.

15. The capacitor structure of claim 7, wherein the ferroelectric ceramic is selected from one of PZT and PLZT and the material is iridium oxide having a sheet resistance of no more than 6.30 Ω.

16. The capacitor structure of any one of claims 7 to 15, further comprising a second electrode in contact with the ferroelectric ceramic so that the ferroelectric ceramic is disposed between the first and second electrodes and wherein the first electrode is iridium and the second electrode is iridium oxide.

17. The capacitor structure of any one of claims 1 to 16, wherein the ferroelectric ceramic is selected from one of PZT and PLZT.
